Europäisches Patentamt

European Patent Office

Office européen des brevets

(11) Publication number: 0 264 932
A1

## (12) EUROPEAN PATENT APPLICATION

(21) Application number: 87115444.9

(22) Date of filing: 21.10.87

(51) Int. Cl.⁴: **H01L 29/80** , **H01L 29/205**

(30) Priority: 24.10.86 JP 254180/86
24.10.86 JP 254181/86

(43) Date of publication of application:
27.04.88 Bulletin 88/17

(84) Designated Contracting States:
**DE FR GB NL**

(71) Applicant: **SUMITOMO ELECTRIC INDUSTRIES LIMITED**
**No. 15, Kitahama 5-chome Higashi-ku**
**Osaka-shi Osaka 541(JP)**

(72) Inventor: **Sasaki, Goro c/o Yokohama Works**
**of Sumito**
**Electric Industries Ltd. No. 1, Taya-cho**
**Sakae-ku Yokohama-shi Kanagawa(JP)**

(74) Representative: **Patentanwälte Grünecker,**
**Kinkeldey, Stockmair & Partner**
**Maximilianstrasse 58**
**D-8000 München 22(DE)**

(54) **Field effect transistor.**

(57) A field effect transistor comprises an InP substrate, an n-tupe semiconductor layer formed on the InP substrate, a GaInAs layer formed on the n-type semiconductor layer, no impurities being added to the GaInAs layer, an AlInAs layer formed on the GaInAs layer, a control electrode provided on the AlInAs layer, and a source electrode and a drain electrode provided at both the sides of the control electrode so as to make an ohmic contact to the GaInAs layer.

## FIG. 2

EP 0 264 932 A1

## FIELD EFFECT TRANSISTOR

### BACKGROUND OF THE INVENTION

The present invention relates to a field effect transistor for a high-frequency amplification circuit, a high-speed integrated circuit, an opto electronic integrated circuit or the like.

A number of conventional transistors in which two-dimensional electrons brought on the the boundary of a heterojunction are used, were proposed as disclosed in Japanese Patent publication No. 53714/84, Japanese Patent Application (OPI) No. 45079/81 (the term "OPI" as used herein means an "unexamined published application") and Japanese Journal of Applied Physics, p. L225, vol. 19, 1980. The substrate of each of the conventional transistors is made of gallium arsenide. In that case, the mobility of the two-dimensional electrons at the room temperature is about 8,000 $cm^2/V\bullet sec$. If the substrate is made of indium phosphide (which is hereinafter expressed as InP), the mobiliy of the two-dimensonal electrons at the room temperature is 12,000 $cm^2/V\bullet sec$, which results in providing a field effect transistor better in high-frequency property and amplification factor.

A two-dimensional-electron transistor having a substrate made of InP is disclosed in the IEEE Electron Device Letters, C.Y. Chen et al, p. 152, vol. EDL-3, 1982.

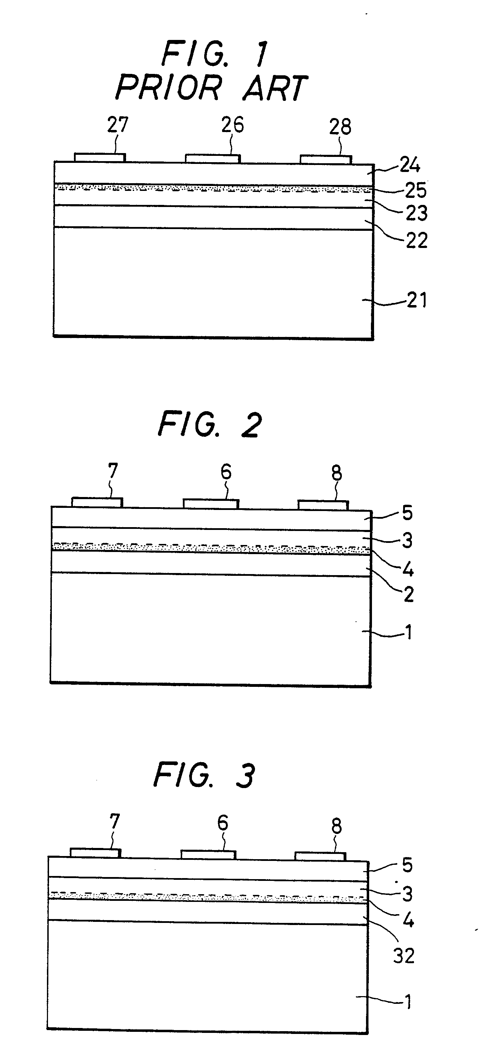

Fig. 1 shows a sectional view of a conventional two-dimensional-electron transistor whose substrate is made of InP. An aluminum-indium-arsenic mixed crystal semiconductor layer (which is hereinafter expressed as AlInAs layer) 22 to which no impurities are added, a gallium-indium-arsenic mixed crystal semiconductor layer(which is hereinafter expressed as GaInAs layer) 23, and an AlInAs layer 24 to which donor impurities are added, are sequentially made on the InP substrate 21. The thickness of the GaInAs layer 23 is more than 1000Å. A control electrode 26 is provided in the AlInAs layer 24. A source electrode 27 and a drain electrode 28 are provided at both the sides of the control electrode 26. A two-dimensional-electron layer 25 is formed at the boundary of the GaInAs layer 23 and the n-type AlInAs layer 24 so that the field effect transistor is made up.

The above-mentioned conventional field effect transistor has a problem that an impurity in the InP substrate 21 diffuses into the AlInAs layer 22 to make it difficult to obtain a good pinch off property of the field-effect transistor. The transistor has another problem that the properties thereof are likely to be affected by the substrate so that fluctuation of the property is apt to occur due to the difference between the lots of the substrates.

### SUMMARY OF THE INVENTION

It is an object of the present invention to provide a field effect transistor whose pinchoff property is good and whose properties are less likely to vary due to the difference between the lots of substrates.

In the field effect transistor provided in accordance with the present invention, an InP layer or an AlInAs layer to which a dondor impurity is added, is formed on an InP substrate; a GaInAs layer to which no impurities are added is made on the InP layer or the AlInAs layer; an AlInAs layer is made on the GaInAs layer; a control electrode is provided on the AlInAs layer; and a source electrode and a drain electrode are provided at both the sides of the control electrode which make ohmic contact to the GaInAs layer.

In the field effect transistor provided in accordance with the present invention, a two-dimensionalelectron layer is formed on the boundary between the n-type InP layer or the n-type AlInAs layer and the GaInAs layer. The control electrode needs to be provided in order to control the concentration of electrons in the two-dimensional-electron layer. The control electrode needs to make non-ohmic contact. Although Schottky contact is generally used as non-ohmic contact, it is usually difficult to make the Schottky contact to the GaInAs layer. For that reason, according to the present invention, the Schottky contact is not made directly to the GaInAs layer, but the AlInAs layer to which it is easy to generate non-ohmic contact is made on the GaInAs layer and the control electrode is thereafter provided on the AlInAs layer.

An impurity either may be added to the AlInAs layer to provide the layer with the p-type or n-type of electric conduction, or may not be added thereto. In other words, an appropriate electric conduction type is selected for the AlInAs layer depending on the desired properties of the field effect transistor. For example, when the dielectric strength of the field effect transistor against the input voltage to the control electrode is to be enhanced, it is preferable to add no impurities to the AlInAs layer. When the threshold voltage of the field effect transistor is to be made positive, the AlInAs layer is provided with the p-type of electric conduction.

When the magnitude of the drain current of the field effect transistor is to be made large, the AlInAs layer is provided with the n-type of electric conduction.

Since the n-type InP layer or the n-type AlInAs layer is made on the InP substrate in accordance with the present invention the influence of an impurity which diffuses from the InP substrate is reduced. Normally, the concentration of the impurity which diffuses from the InP substrate is about $10^{16}$ $cm^{-3}$ and the depth of the diffusion is about $300\text{Å}$. Therefore, the influence of the impurity which diffuses from the InP substrate can be reduced by making the thickness of the n-type layer and the concentration of donor impurity thereof larger than about $300\text{Å}$ and $10^{16}$ $cm^{-3}$, respectively.

## BRIEF DESCRIPTION OF THE DRAWINGS

Fig. 1 is a sectional view showing a conventional field effect transistor, and

Figs 2 and 3 are sectional views showing field effect transistors according to first and second embodiments of the present invention, respectively.

## DETAILED DESCRIPTION OF THE PREFERRED EMBODIMENTS

A first embodiment of the present invention, which is a field effect transistor, is hereafter described with reference to Fig. 2. A first AlInAs layer 2 doped with a donor impurity is formed on a semi-insulating InP substrate 1 by an organic metal gas-phase growth method or a gas-source MBE (molecular-beam epitaxy method )at the substrate temperature of 600°C to 650°C. Si, S, Se or the like is supplied in the form of a hydride as the donor impurity. The concentration of the impurity and the thicknes of the first AlInAs layer 2 are set at about $1 \times 10^{17}$ to $5 \times 10^{18}$ $cm^{-3}$ and at $500\text{Å}$ to $2,000\text{Å}$, respectively. Usually, the concentration of an impurity which diffuses from the InP substrate 1 is about $10^{16}$ $cm^{-3}$ and the depth of the diffusion is about $300\text{Å}$. Therefore, the influence of the impurity which diffuses from the InP substrate 1 is almost all eliminated by making the concentration of the donor impurity and the thickness of the first AlInAs layer 2 larger than that of the diffusing impurity and the depth of the diffusion thereof, respectively.

A GaInAs layer 3 to which no impurities are added is formed at a thickness of about $150\text{Å}$ to $2,000\text{Å}$. It is possible to make an field effect transistor having superior amplification characteristics when the thickness of the AlInAs layer 3 is thin. However, if the thickness is less than $150\text{Å}$, the density of two-dimensional electrons becomes small so that the range of gate voltage with the amplification operation becomes narrow. A second AlInAs layer 5 is then made at a thickness of about $200\text{Å}$ to $2.,000\text{Å}$. The composition of the mixed crystal of each of the first AlInAs layer 2, the GaInAs layer 3 and the second AlInAs layer 5 is made such that the lattice mismatch thereof to the InP substrate 1 is 0.1% or less.

An impurity either may be added to the second AlInAs layer 5 to provide the layer with the p-type or n-type of electric conduction, or may not be added thereto, depending on the desired properties of the field effect transistor. For example, when the high input withstand voltage is needed, the impurity is not added. When the drain current is to be made large, the second AlInAs layer 5 is provided with the n-type of electric conduction. When the threshold voltage is to be made positive, the layer 5 is provided with the p-type of electric conduction. To provide the layer 5 with the n-type of electric conduction, the impurity such as Si, S and Se is added thereto at a concentration of about $10^{16}$ $cm^{-3}$ to $10^{18}$ $cm^{-3}$. To provide the layer 5 with the p-type of electric conduction, the impurity such as Zn, Mg and Mn is added thereto at a concentration of about $10^{16}$ $cm^{-3}$ to $10^{18}$ $cm^{-3}$. According to the present invention, even if the impurity is not added to the AlInAs layer 5, the two-dimensional electron layer 4 is formed and a leak current between the source and the gate is decreased so that the noise of the field effect transistor can be suppressed. However, in the conventional field effect transistor as shown in Fig. 1, if the impurity is not added to the AlInAs layer 24, the two-dimensional electron layer 25 is not formed so that the property of field effect transistor is not obtained.

An ohmic contact metal formed of an Au-Ge alloy is evaporated and is subjected to alloying at a temperature of, for example, 400°C to make a course electrode 7 and a drain electrode 8. Finally, a control electrode 6 is made of Al,Pt, Au, W, WSi or the like by an evaporation method or the like, thus completing the field effect transistor.

Fig. 3 is a sectional view showing a second embodiment of the present invention. The same reference numeral in Figs. 1 and 3 disignate the same parts. The second embodiment is identical to the first embodiment except that an n-type InP layer 32 is formed on the InP substrate 1.

The InP layer 32 is made on the semi-insulating InP substrate 1 by the organic metal gas-phase growth method or the gas-source molecular-beam epitaxy method at the substrate temperature of 600°C to 650°C with being added by a donor impurity such as Si, S and Se. At that time, the concentration of the donor impurity and the thickness of the InP layer 32 are set at about $1 \times 10^{17}$

cm⁻³ to 5 x 10¹⁸ cm⁻³ and at 500Å to 2,000Å, respectively. The GaInAs layer 3, AlInAs layer 5, control electrode 6, source electrode 7 and drain electrode 8 are formed by the same method as in the first embodiment.

According to the field effect transistor of the first embodiment or the second embodiment, since the n-type AlInAs layer 2 or the n-type InP layer 32 is formed on the InP substrate 1, the influence of an impurity which diffuses from the InP substrate is reduced. Accordingly, the field effect transistor having superior high-frequency property and amplifying property can be manufacturing with high reproducibility.

**Claims**

1. A field effect transistor, comprising:
an InP substrate;
an n-type semiconductor layer formed on said InP substrate;
a GaInAs layer formed on said n-type semiconductor layer, no impurities being added to said GaInAs layer;
an AlInAs layer formed on said GaInAs layer;
a control electrode provided on said AlInAs layer; and
a source electrode and a drain electrode provided at both the sides of said control electrode so at to make an ohmic contact to said GaInAs layer.

2. A field effect transistor as claimed in claim 1, wherein said n-type semiconductor layer is an AlInAs layer.

3. A field effect transistor as claimed in claim 1, wherein said n-type semiconductor is an Inp layer.

4. A field effect transistor as claimed in claim 1, wherein no impurities are added to said AlInAs layer.

5. A field effect transistor as claimed in claim 1, wherein the electrical conduction of said AlInAs layer is of a p-type.

6. A field effect transistor as claimed in claim 1, wherein the electrical conduction of said AlInAs layer is of an n-type.

7. A field effect transistor as claimed in claim 1, wherein said GaInAs layer has a thickness of 150 -1000Å.

8. A field effect transistor as claimed in claim 1, wherein said n-type semiconductor layer includes impurities having the concentration of 1x 10¹⁷ -5 x 10¹⁸ cm⁻³ and has a thickness of 500 - 2000Å.

## FIG. 1
## PRIOR ART

## FIG. 2

## FIG. 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 050 064 (THOMSON CSF)<br>* Page 4, lines 12-20; page 4, line 28 - page 5, line 4; page 5, lines 20-28; figure 5 * | 1,2,6-8 | H 01 L 29/80<br>H 01 L 29/205 |
| Y | | 3-5 | |
| Y | INTERNATIONAL ELECTRON DEVICES MEETING, TECHNICAL DIGEST, Washington, DC, 1st-4th December 1985, pages 321-323, IEEE, New York, US; K.S. SEO et al.: "DC and microwave performance of In0.53Ga0.47As-In0.52Al0.48As single quantum well MISFETS" * Whole document * | 3,4 | |
| A | Idem | 1,2,7,8 | |
| Y | EP-A-0 114 962 (INTERNATIONAL BUSINESS MACHINES CORP.) * Page 6, line 29 - page 7, line 7; figures 2.1-2.3 * | 5 | |
| A | | 4,6 | TECHNICAL FIELDS SEARCHED (Int. Cl.4) |
| X | EP-A-0 147 196 (HITACHI LTD) * Page 6, lines 6-21; figures 3,5b * | 1,2,4 | H 01 L |
| A | | 3,8 | |
| A | GB-A-2 012 480 (THE PLESSEY CO. LTD) * Page 2, lines 52-56,88-126; figure 4 * | 1,3,8 | |
| X | EP-A-0 051 271 (HITACHI LTD) * Page 11, line 17 - page 12, line 1; figure 3 * | 1,2,5,7 | |

The present search report has been drawn up for all claims

| Place of search | Date of completion of the search | Examiner |
|---|---|---|
| THE HAGUE | 27-11-1987 | MORVAN D.L.D. |